Europäisches Patentamt

European Patent Office

Office européen des brevets

(11) Publication number: **0 104 818**
**A2**

(12) **EUROPEAN PATENT APPLICATION**

(21) Application number: **83305234.3**

(22) Date of filing: **08.09.83**

(51) Int. Cl.³: **H 01 J 37/317**
**H 01 J 37/02**

(30) Priority: **29.09.82 US 426326**

(43) Date of publication of application:
**04.04.84 Bulletin 84/14**

(84) Designated Contracting States:
**DE FR GB**

(71) Applicant: **EATON CORPORATION**
**100 Erieview Plaza**
**Cleveland Ohio 44114(US)**

(72) Inventor: **King, Monroe Lee**
**10013 Woodland Village**
**Austin Texas 78750(US)**

(72) Inventor: **Parslow, Leroy George**
**1201 N. Kent Lane**
**Cedar Park Texas 78613(US)**

(74) Representative: **Douglas, John Andrew**
**Eaton House Staines Road**
**Hounslow Middlesex TW4 5DX(GB)**

(54) Ion implantation device.

(57) A device for neutralizing the positive static charge which tends to build up on a target (24) in an ion implanter (10). A ring (30) is placed in surrounding relation to the ion beam (17) just upstream of the target, and is electrically biased at a relatively low negative potential. Portions of the overscan beams (17b) of the implanter strike the negatively biased ring generating secondary electrons which are then directed to the positively charged target tending to neutralize such charge.

Fig. I

-1-

ION IMPLANTATION DEVICE

The present invention relates generally to apparatus for implanting ions in semiconductor wafers, and more specifically to apparatus for neutralizing the surface charge on materials undergoing ion implantation. Ion beams used for ion implantation are composed of ions containing a net positive electrical charge. The existence of such charge is generally beneficial to the process since small quantities of atoms can easily be measured extremely accurately by electronic means. In the production of semiconductors the ion implantation target is most likely to be a wafer of silicon or other material which is a poor electrical conductor; therefore, a positive charge tends to buildup on the surface of the target. The buildup of such charge on the target can cause damage to the target.

Past attempts to combat this problem have included a device employing a hot filament placed adjacent the Faraday Cylinder of an implantation apparatus. In this device primary electrons flow from the filament through an aperture in one side in the Faraday Cylinder and then strike the opposite side of the Cylinder, thus generating a large quantity of low energy secondary electrons, most of which neutralize the space charge of the ion beam. While such devices function effectively, they require a separate filament and a relatively large power supply to operate. Because of the presence of the hot filament there is also a tendency to contaminate the target.

-2-

What the present invention seeks to provide is a means to neutralize the charge on an ion implantation target which requires a minimum of additional components and power supplies for operation.

To meet the above objective the present invention provides a negative biased electrode placed near the target in the path of the overscan portion of the ion beam. This produces a large quantity of secondary electrons which are then directed toward the target by the electric field which biases the electrode, thus neutralizing any positive charge which tends to buildup on the target. Specifically, the invention includes a ring received within the Faraday Cylinder adjacent the target. The Faraday Cylinder is maintained at a negative potential between -45 and -90 volts for measurement and other purposes; therefore, the ring in contact with the Cylinder is also at that potential. In accordance with one aspect of the invention the ring is formed with an internal angle tapering inwardly toward the end adjacent the wafers, thus increasing the quantity of secondary electrons per incident ion resulting from the overscan beam striking the ring.

Other objectives and advantages of the invention will be apparent from the following description when considered in conjunction with the accompanying drawings, wherein:

FIGURE 1 is a schematic plan view of an ion implantation apparatus incorporating the invention; and

FIGURE 2 is an enlarged view, partly in section, schematically illustrating the portion of the apparatus of Figure 1 which includes the invention.

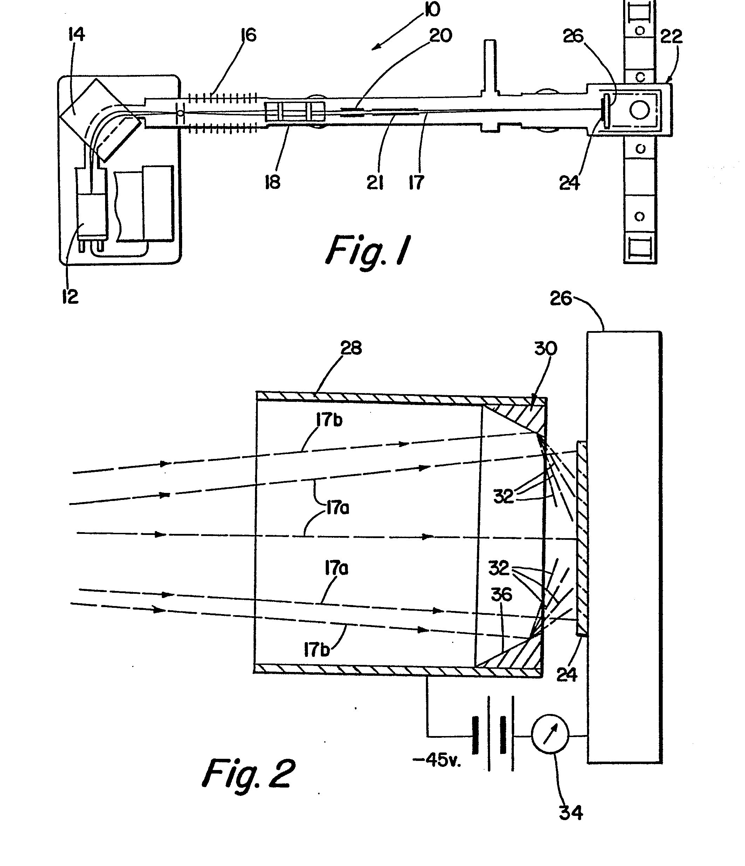

Referring to Figure 1, there is illustrated an ion implantation apparatus 10. Ions from an ion source 12 are redirected by an analyzing magnet 14 before being directed through an accelerator column 16. The ion beam 17 then passes through a lens system 18, and past a series of scan plates 20 and 21 before entering an end station 22 where a target wafer 24 is received. The ion implantation apparatus 10 per se is well known in the art and will not be described in further detail herein.

Referring also to FIG. 2, within the end station 22, the wafer 24 is mounted on a suppport plate 26, which is maintained at a relatively low positive potential with respect to a Faraday Cylinder 28, typically 45 volts. The ion beam 17 is made up of primary beam elements 17a which actually strike the target, as shown, and a relatively small number of overscan beam elements 17b which ordinarily do not strike the target.

In the illustrated embodiment, the invention is illustrated in association with a Faraday Cylinder 28, which is maintained at relatively low negative potential with respect to the support plate 26, and which is conventionally used to contain secondary emissions from the target.

In accordance with the invention, a metallic ring 30 is mounted within the Cylinder and in electrical contact with it. In operation, as the overscan beam elements 17b strike the negatively biased ring 30, secondary electrons are produced which are then directed toward the positively charged target surface, as indicated by the lines designated 32, thus tending to

-4-

neutralize the charge. A meter 34 can be inserted in this circuit so as to measure the secondary electron current.

In the illustrative embodiment, the Faraday Cylinder is shown as being biased at -45 volts. It can be appreciated, however, that the actual voltage is not critical and that the potential applied to the Cylinder can be as low as -10 volts for purposes of this invention. Also, while the ring 30 is preferably mounted within a cylinder such as Faraday Cylinder 28 for ease of mounting, the ring can be mounted separately adjacent the target 24 so long as it is maintained at a negative potential with respect to the target.

In accordance with one aspect of the invention, the inner surface 36 of the ring 30 is formed at an angle to the centerline of the beam, as shown in the preferred embodiment. The angled surface has the effect of emmiting the secondary electrons toward the target which serves to enhance the neutralizing effect of the invention, and the low incident angle increases the quantity of secondary electrons; however, it should be understood that the electrons are directed toward the target primarily because of the opposite charge condition between the ring and the target; therefore, the actual configuration of the ring, including the value and direction of the angle of the inner surface 36 relative to the beam line, is not critical.

WE CLAIM:

1.   An ion implanter (10) including an ion source (12); means (14, 16, 18, 20, 21) for extracting ions from said source and forming said ions into a beam (17); a target (24) disposed in the path of said beam; and means for directing electrons toward said target; characterized in that said directing means comprises a metallic ring (30) disposed upstream of said target and in surrounding relation to said beam, and means electrically biasing said ring to a negative potential.

2.   Apparatus as claimed in claim 1, in which said beam (17) includes primary beam elements (17a) which intersect said target, and overscan beam elements (17b) which diverge beyond the outer edge of the target, said ring being disposed in the path of said overscan beam elements whereby said overscan beam elements strike said ring to generate secondary electrons (32) directed toward said target.

3.   Apparatus as claimed in claim 2, in which said ring includes an inner surface (36) which is angled inwardly adjacent the target.

4.   Apparatus as claimed in claims 1, 2 or 3, wherein said ion implanter includes a Faraday Cylinder (28) disposed upstream of said target, said ring being disposed within said Faraday Cylinder.

5.   An ion implanter (10) including an ion source (12); means (14, 16, 18, 20, 21) for extracting ions from said source and forming said ions into a beam (17); a target (24) disposed in the path of said beam;

and a cylindrical member (28) disposed with its axis parallel to said beam upstream of said target, said cylinder being electrically biased to a negative potential with respect to said target; characterized by a metallic ring (30) received within said cylindrical member and disposed at or near the end of said cylindrical member nearest to said target, said ring being in electrical contact with said cylindrical member.

6. Apparatus as claimed in claim 5, in which said beam (17) includes primary beam elements (17a) which intersect said target, and overscan beam elements (17b) which diverge sufficiently to miss said target, said ring being disposed in the path of said divergent overscan beam elements whereby said overscan beam elements strike said ring thereby generating secondary electrons which are directed toward said target by the electric field biasing said ring.

7. Apparatus as claimed in claim 6, in which said ring includes an inner surface (36) which is angled inwardly adjacent the target.

*Fig. I*

*Fig. 2*